# EUROPÄISCHE PATENTSCHRIFT

(11) **EP 4 104 650 B1**
(45) Veröffentlichungstag und Bekanntmachung des Hinweises auf die Patenterteilung: **20.08.2025**
(21) Anmeldenummer: 21702588.1
(22) Anmeldetag: 25.01.2021
(51) Int. Cl.: H05K 5/00, H05K 5/02, H05K 7/14

(54) **ELEKTROGERÄT, INSBESONDERE UMRICHTER ODER UMRICHTERMOTOR, MIT EINEM DECKELTEIL UND SIGNALELEKTRONIK**
ELECTRICAL DEVICE, IN PARTICULAR CONVERTER OR CONVERTER MOTOR, WITH A COVER PART AND SIGNAL ELECTRONICS SYSTEM
DISPOSITIF ÉLECTRIQUE, EN PARTICULIER CONVERTISSEUR OU MOTEUR DE CONVERTISSEUR, COMPRENANT UNE PARTIE COUVERCLE ET UN SYSTÈME ÉLECTRONIQUE DE SIGNAL

(30) Priorität: 12.02.2020 DE 102020000909
(43) Veröffentlichungstag der Anmeldung: 21.12.2022
(73) Patentinhaber: SEW-EURODRIVE GmbH & Co. KG, 76646 Bruchsal (DE)
(72) Erfinder: MAYER, Ralph, 76698 Ubstadt-Weiher (DE); POLLEY, Jan, 76669 Bad Shönborn (DE)
(86) Internationale Anmeldenummer: PCT/EP2021/025026
(87) Internationale Veröffentlichungsnummer: WO 2021/160339

(56) Entgegenhaltungen:
- EP-A2- 1 104 080
- DE-A1- 102005 032 075
- DE-A1- 102010 047 762

## Beschreibung

Die Erfindung betrifft ein Elektrogerät, insbesondere Umrichter oder Umrichtermotor, mit einem Deckelteil und Signalelektronik.

Es ist allgemein bekannt, dass eine Signalelektronik in einem Gehäuse anordenbar ist.

**Aus der** EP 1 104 080 A2 **ist als nächstliegender Stand der Technik ein Deckel für einen Motoranschlusskasten bekannt.**

**Aus der** DE 10 2005 032075 A1 **ist ein Speicher mit Datenabgleich aus einem und für einen Antriebsregler einer Maschine bekannt.**

**Aus der** DE 10 2010 047762 A1 **ist ein Umrichtermotor bekannt.**

Der Erfindung liegt daher die Aufgabe zugrunde, ein Elektrogerät für verschiedene Anwendungen einsatzfähig und/oder mit geringem Aufwand reparierbar zu gestalten.

Erfindungsgemäß wird die Aufgabe bei dem Elektrogerät nach den in Anspruch 1 angegebenen Merkmalen gelöst.

Wichtige Merkmale der Erfindung bei der Vorrichtung und ein Verfahren sind, dass das Elektrogerät, insbesondere Umrichter oder Umrichtermotor, mit einem Deckelteil und Signalelektronik vorgesehen ist,
wobei die Signalelektronik eine erste Leiterplatte aufweist und eine mit der ersten Leiterplatte, insbesondere mittels elektrischer Steckverbindung, elektrisch steckverbundene Speichereinheit,
wobei die Speichereinheit eine Schaltereinheit, insbesondere Wahlschalter, insbesondere DIP-Schalter, aufweist,
insbesondere wobei die Signalelektronik, insbesondere die Betriebsart der Signalelektronik, als abhängig von der Schalterstellung der Schaltereinheit unterschiedliches AS-Interface-Slave-Profil und/oder als abhängig von der Schalterstellung der Schaltereinheit unterschiedlicher AS-Interface-Slave-Typ fungiert.

Von Vorteil ist dabei, dass durch die Schalterstellung der Schaltereinheit die Betriebsart vorgebbar ist. Somit müssen für zwei verschiedene Betriebsarten nicht zwei unterschiedliche

Elektrogeräte hergestellt werden sondern durch das Vorgeben der Schalterstellung ist die Betriebsart vorgebbar. Nachteilig ist bei der Erfindung, dass eine Schaltereinheit vorgesehen werden muss. Jedoch ist somit nur eine einzige Variante herzustellen und es müssen nicht zwei unterschiedliche Varianten hergestellt werden. Auf diese Weise ist der Aufwand derart verringert, dass der Zusatzaufwand für die Schaltereinheit überkompensiert ist.

Als Betriebsart ist hier insbesondere die Betriebsart eines AS-Interface-Slave-Profils oder - Typs vorsehbar.

Bei einer vorteilhaften Ausgestaltung ist ein Wandteil mit dem Deckelteil verbunden,
wobei die erste Leiterplatte zwischen dem Wandteil und dem Deckelteil angeordnet ist, insbesondere wobei die erste Leiterplatte mit dem Deckelteil verbunden ist. Von Vorteil ist dabei, dass das Wandteil mit dem Deckelteil einen Raumbereich schützt, in welchem die erste Leiterplatte angeordnet ist. Somit ist die Leiterplatte samt den darauf bestückten Bauelementen der Signalelektronik entsprechend geschützt. Das Wandteil ist dabei aber auch als elektrisches und/oder thermisches Isolationsmittel vorsehbar. Auf diese Weise ist die Signalelektronik von einer Leistungselektronik thermisch trennbar.

Bei einer vorteilhaften Ausgestaltung ist das Wandteil aus Kunststoff gefertigt und/oder das Deckelteil ist aus Metall, insbesondere als Aluminiumdruckgussteil, gefertigt, insbesondere wobei das Wandteil als Wärmesperre fungiert, insbesondere als Wärmesperre zwischen der Signalelektronik und einem Elektromotor, mit dessen Gehäuseteil das Deckelteil verbunden ist. Von Vorteil ist dabei, dass das Deckelteil mit einem Gehäuseteil eines Elektromotors oder mit einem mit einem Gehäuseteil eines Elektromotors verbundenen Unterteils verbindbar ist, in welchem auch eine Leistungselektronik anordenbar ist. Somit ist ein Umrichtermotor ausbildbar, bei welchem die Signalelektronik über das Deckelteil entwärmbar ist und die Leistungselektronik über das Unterteil und/oder das Gehäuseteil. Somit ist der Elektromotor, insbesondere dessen Statorwicklung, zusammen mit der Leistungselektronik über das Gehäuseteil und das Unterteil gemeinsam entwärmbar, wenn dazwischen keine weitere Wärmesperre vorgesehen wird.

**Erfindungsgemäß** weist die Speichereinheit eine weitere Leiterplatte auf, die in einem Gehäuse der Speichereinheit aufgenommen ist,
wobei das Gehäuse ein Unterteil und ein mit dem Unterteil verbundenes Oberteil aufweist. Von Vorteil ist dabei, dass die weitere Leiterplatte geschützt angeordnet ist und ein geführtes elektrisches Steckverbinden der weiteren Leiterplatte mit der ersten Leiterplatte ausführbar ist.

Bei einer vorteilhaften Ausgestaltung sind am Unterteil zumindest zwei elastisch auslenkbare, insbesondere an einander gegenüberliegenden Seiten des Unterteils angeordnete, Bereiche ausgebildet,
an welchen jeweils eine erste Rastnase ausgebildet ist, insbesondere zur formschlüssigen Verbindung. Von Vorteil ist dabei, dass die Bereiche elastisch aufeinander zu bewegbar sind und dadurch die Speichereinheit einführbar ist in entsprechende Ausnehmungen des Wandteils und der ersten Leiterplatte.

Bei einer vorteilhaften Ausgestaltung ist zwischen dem Wandteil und dem Deckelteil eine zweite Leiterplatte angeordnet,
insbesondere wobei die zweite Leiterplatte parallel zur ersten Leiterplatte und/oder von der ersten Leiterplatte beabstandet angeordnet ist. Von Vorteil ist dabei, dass weitere Signalelektronik vorsehbar ist. Außerdem ist die zweite Leiterplatte zwischen dem Wandteil und der ersten Leiterplatte anordenbar.

Bei einer vorteilhaften Ausgestaltung ist am Unterteil zumindest ein Stiftbereich ausgebildet, welcher in eine Ausnehmung der ersten Leiterplatte eingesteckt ist, insbesondere zur Führung der Speichereinheit beim Steckverbinden der weiteren Leiterplatte, insbesondere von als Kontakte fungierende Leiterbahnen der weiteren Leiterplatte, mit der ersten Leiterplatte, insbesondere mit einem auf der ersten Leiterplatte bestückten Steckverbinderteil. Von Vorteil ist dabei, dass ein Verkanten beim Steckverbinden der weiteren Leiterplatte mit der ersten Leiterplatte vermeidbar ist.

Bei einer vorteilhaften Ausgestaltung ist die erste Leiterplatte mit einem Steckverbinderteil, insbesondere Buchsenleiste, bestückt,
wobei die weitere Leiterplatte der Speichereinheit steckverbunden ist mit dem Steckverbinderteil,
insbesondere wobei an der weiteren Leiterplatten angeordneten Leiterbahn als Kontakte fungieren, die mit Kontakten des Steckverbinderteils elektrisch lösbar verbunden sind. Von Vorteil ist dabei, dass eine einfache Herstellung ermöglicht ist.

Bei einer vorteilhaften Ausgestaltung weisen die elastisch auslenkbaren Bereiche an ihrer von der weiteren Leiterplatten abgewandten Seite einen geriffelten, gerändelten und/oder aufgerauten Bereich auf, insbesondere zur Erhöhung der Griffigkeit. Von Vorteil ist dabei, dass eine sichere und einfache Handhabung bei der Herstellung ermöglicht ist.

Bei einer vorteilhaften Ausgestaltung liegt die Rastnase an der der ersten Leiterplatte zugewandten Seite des Wandteils an. Von Vorteil ist dabei, dass die Speichereinheit durch eine Ausnehmung des Wandteils einführbar, während es von den Stiftbereichen an der ersten Leiterplatte geführt wird, und nach Bewirken der Steckverbindung zwischen der weiteren und der ersten Leiterplatte an dem Wandteil formschlüssig begrenzbar ist.

Bei einer vorteilhaften Ausgestaltung liegt eine am Unterteil und/oder Oberteil ausgebildete, insbesondere ausgeformte, Rastnase an der von der ersten Leiterplatten abgewandten Seite des Wandteils an. Von Vorteil ist dabei, dass das Wandteil formschlüssig mit der Speichereinheit verbunden ist.

Bei einer vorteilhaften Ausgestaltung weist die weitere Leiterplatte Vertiefungen, insbesondere Einkerbungen, auf, in welche an dem Oberteil oder Unterteil ausgebildeten, insbesondere ausgeformten, elastisch verformbaren Rastnasen hineinragen. Von Vorteil ist dabei, dass die Speichereinheit an der weiteren Leiterplatte formschlüssig gehalten ist.

Bei einer vorteilhaften Ausgestaltung weist die am Unterteil und/oder Oberteil ausgebildete, Rastnase eine Schrägung auf, welche mit zunehmendem Abstand von dem oder den Stiftbereichen einen abnehmenden Abstand zur weitere Leiterplatte aufweist. Von Vorteil ist dabei, dass die die Speichereinheit formschlüssig am Wandteil befestigbar ist.

Bei einer vorteilhaften Ausgestaltung weist die jeweilige, am elastisch auslenkbaren Bereich ausgebildete Rastnase eine Einführschräge auf, welche mit zunehmendem Abstand von dem oder den Stiftbereichen einen zunehmenden Abstand zur weiteren Leiterplatte aufweist. Von Vorteil ist dabei, dass eine Begrenzung am Wandteil erreichbar ist.

Bei einer vorteilhaften Ausgestaltung ist die weitere Leiterplatte mit der Schaltereinheit und einem insbesondere langzeitstabilen Datenspeicher bestückt. Von Vorteil ist dabei, dass die Parameter eines Elektrogeräts in einfacher Weise an ein anderes Elektrogerät weitergebbar sind.

Bei einer vorteilhaften Ausgestaltung ist am Unterteil und/oder Oberteil ein Zentrierbolzen ausgebildet, der von dem oder den Stiftbereichen beabstandet ist und in eine weitere, insbesondere durchgehende, Ausnehmung der ersten Leiterplatte ragt. Von Vorteil ist dabei, dass eine verbesserte Zentrierung der Speichereinheit ermöglicht ist.

**Erfindungsgemäß** ist das Oberteil mit dem Unterteil formschlüssig, insbesondere mittels Klipsverbindung, verbunden. Von Vorteil ist dabei, dass eine einfache aber sichere Verbindung ausführbar ist.

Bei einer vorteilhaften Ausgestaltung weist das Wandteil Ausnehmungen auf, durch welche hindurch mit einem Werkzeug Eingabeelemente, insbesondere Potentiometer, Drehschalter oder weitere DIP-Schalter, bedienbar sind. Von Vorteil ist dabei, dass einerseits das Wandteil als Isolationsmittel fungiert und andererseits trotzdem die Bedienung der Eingabemittel durch das Wandteil hindurch ermöglicht wird.

Bei einer vorteilhaften Ausgestaltung ist auf der ersten Leiterplatte zumindest ein Potentiometer angeordnet und das Deckelteil weist eine mit einem Verschlussteil, insbesondere Verschlussschraube, abgedeckte Ausnehmung auf,
wobei das Potentiometer mittels eines bei entfernter Verschlussschraube durch die Ausnehmung hindurchragendem Schraubendreher betätigbar ist. Von Vorteil ist dabei, dass das Potentiometer in einem abgedichteten Raumbereich anordenbar ist und durch Lösen, also Abschrauben, der Verschlussschraube zugänglich für die Bedienung ist.

Weitere Vorteile ergeben sich aus den Unteransprüchen. Die Erfindung ist nicht auf die Merkmalskombination der Ansprüche beschränkt. Für den Fachmann ergeben sich weitere sinnvolle Kombinationsmöglichkeiten von Ansprüchen und/oder einzelnen Anspruchsmerkmalen und/oder Merkmalen der Beschreibung und/oder der Figuren, insbesondere aus der Aufgabenstellung und/oder der sich durch Vergleich mit dem Stand der Technik stellenden Aufgabe.

Die Erfindung wird nun anhand von schematischen Abbildungen näher erläutert:

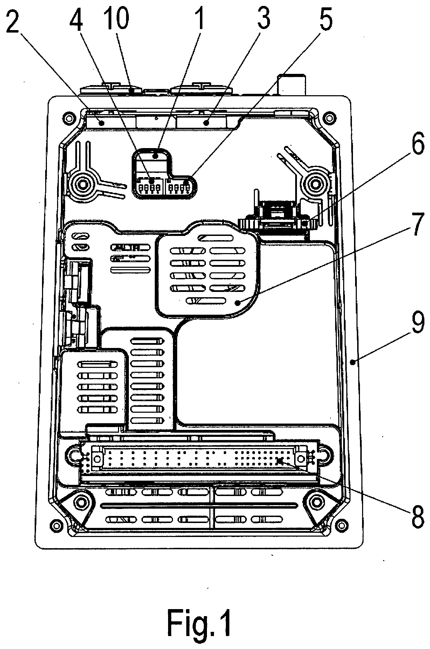

In der Figur 1 ist eine Draufsicht auf ein Deckelteil 9 eines erfindungsgemäßen Umrichtermotors dargestellt.

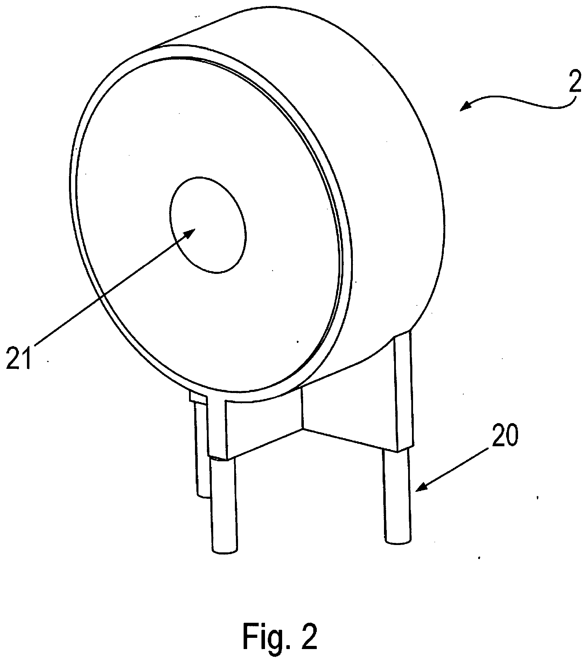

In der Figur 2 ist ein auf einer im Deckelteil 9 aufgenommenen, ersten Leiterplatte 70 bestückbares Potentiometers 2 in Schrägansicht dargestellt.

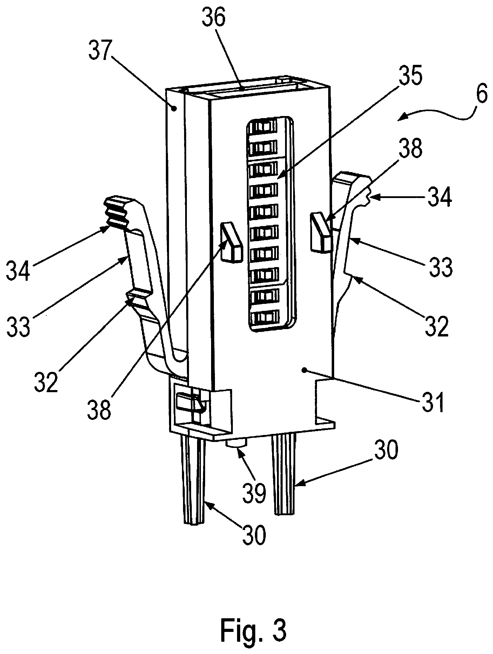

In der Figur 3 ist eine in die erste Leiterplatte 70 eingesteckte Speichereinheit 6 in Schrägansicht dargestellt.

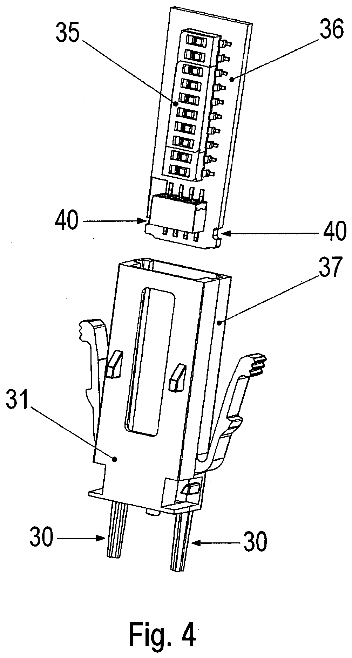

In der Figur 4 ist die Speichereinheit 6 teilweise explodiert in Schrägansicht dargestellt.

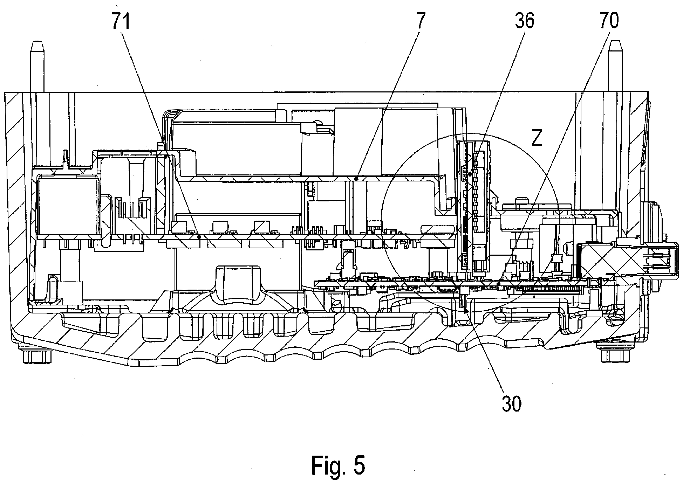

In der Figur 5 ist die Verrastung der Speichereinheit 6 an einem als Isolationsmittel fungierenden Wandteil 7 in einer Schnittansicht veranschaulicht.

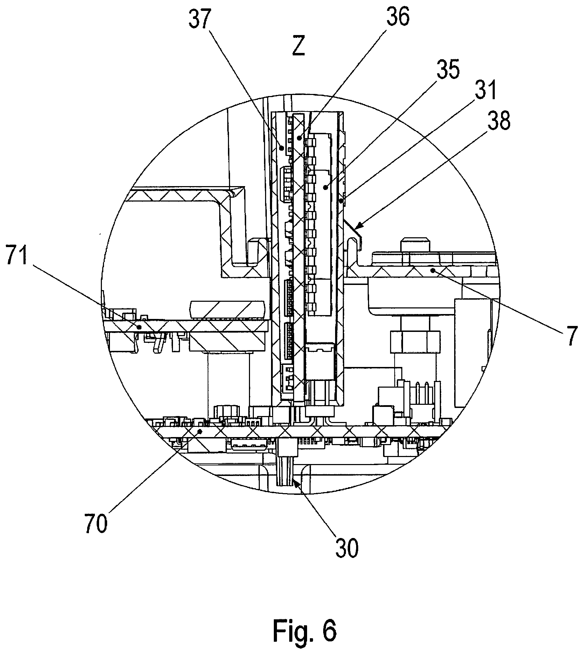

In Figur 6 ist ein Ausschnitt der Figur 5 vergrößert dargestellt.

Wie in den Figuren dargestellt, ist das Deckelteil 9 topfartig ausgeführt, so dass in ihm eine erste Leiterplatte 70 aufgenommen und mittels Schrauben an das Deckelteil 9 angedrückt ist, welche in Gewindebohrungen des Deckelteils 9 eingeschraubt sind.

Das Deckelteil 9 ist vorzugsweise aus Metall, insbesondere Aluminiumdruckguss, ausgeführt.

Ein vorzugsweise aus Kunststoff ausgeführtes Wandteil 7 ist ebenfalls am Deckelteil 9 befestigt und deckt die Leiterplatte 70 im Wesentlichen ab, so dass die Leiterplatte 70 in dem vom Wandteil 7 und dem Deckelteil 9 umrandeten Raumbereich angeordnet ist.

Die Leiterplatte 70 ist mit elektronischen Bauelementen und einem Drehschalter 1, welches durch eine Ausnehmung des Wandteils 7 hindurch zugänglich und/oder bedienbar, insbesondere drehbar ist. Allerdings ist das Deckelteil 9 zuvor von einem Unterteil zu lösen, welches auf einem Motorgehäuse befestigt ist oder einstückig mit diesem ausgebildet ist.

Außerdem ist die Leiterplatte 70 mit einem ersten und zweiten Potentiometer (2, 3) bestückt, die derart auf der Leiterplatte 70 angeordnet sind, dass eine Betätigung des jeweiligen Potentiometers (2, 3) ermöglicht ist, wenn eine Verschlussschraube 10 entfernt wird, welche in einer Ausnehmung des Deckelteils 9 angeordnet ist. Somit ist dann ein Werkzeug, wie beispielsweise Schraubendreher, von der äußeren Umgebung durch die Ausnehmung des Deckelteils 9 zum Potentiometer (2, 3) hindurchführbar und das Potentiometer (2, 3) betätigbar.

Die Speichereinheit 6 weist ein Unterteil 37 mit einstückig, insbesondere einteilig, an dem Unterteil 37 ausgebildeten, insbesondere voneinander beabstandeten, Stiftbereichen 30 auf und ein Oberteil 31.

Vorzugsweise sind Oberteil 31 und Unterteil 37 aus Kunststoff gefertigt.

Durch die Ausnehmung im Wandteil 7 sind auch auf der Leiterplatte 70 bestückte DIP-Schalter
(4, 5) betätigbar.

In der Speichereinheit 6 ist eine weitere Leiterplatte 36 angeordnet, welche zumindest mit einem langzeitstabilen Datenspeicher und einem DIP-Schalter 35 bestückt ist.

Somit sind Parameter zur Inbetriebnahme des Umrichters in der Speichereinheit 6 abspeicherbar und eine schnelle Inbetriebnahme ausführbar.

Die Speichereinheit 6 weist ein Unterteil 37 und ein Oberteil 31 auf, die miteinander verbunden, insbesondere klipsverbunden.

Am Unterteil 37 sind Stiftbereiche 30 ausgeformt, so dass eine geführte Verbindung der Speichereinheit 6 ermöglicht ist. Die Führung erfolgt bei der Herstellung, also beim Einstecken der Speichereinheit 6 an der ersten Leiterplatte 70 mittels Einstecken der Stiftbereiche 30 in entsprechende Ausnehmungen der ersten Leiterplatte 70.

Die Leiterplatte 36 weist an zwei Seiten einander gegenüberliegend angeordnete Kerben auf, in welche am Unterteil ausgeformte, elastisch auslenkbare zur Leiterplatte 36 hin hervorragende Nasenbereiche einrasten. Somit ist die Leiterplatte 36 formschlüssig in der Speichereinheit 6 aufgenommen.

Am Unterteil 37 sind an zwei einander gegenüberliegenden Seiten elastisch auslenkbare Bereiche 33 ausgeformt, welche eine Rastnase 32 und einen geriffelten Bereich 34 aufweisen. Die elastisch auslenkbaren Bereiche 33 mit einer Hand aufeinander zu bewegbar und dabei elastisch vorspannbar. Dabei verhindern die geriffelten Bereiche 34 ein Abrutschen der Finger dieser Hand. Während des elastischen Auslenkens der Bereiche 33 wird die Speichereinheit 6 zum Einführen in das Deckelteil 9 in Richtung der längsten Ausdehnung der Stiftbereiche 30 mit den Stiftbereichen 30 durch eine Ausnehmung des Wandteils 7 und durch mindestens zwei Ausnehmungen der ersten Leiterplatte 70 geführt. Auf diese Weise ist eine Zentrierung zur ersten Leiterplatte 70 hin ausführbar, so dass an der weiteren Leiterplatte 36 der Speichereinheit 6 als Kontakte ausgebildete Leiterbahnen in ein auf der Leiterplatte 70 bestücktes Steckverbinderteil, insbesondere Buchsenteil, insbesondere ohne Verkanten einführbar sind. Die Steckverbindung der weiteren Leiterplatte 36 mit der ersten Leiterplatte 70 ist also verkantungsfrei ausführbar wegen der Führung durch die vorauseilend angeordneten Stiftbereiche 30. Zuerst durchdringen die Stiftberieche 30 beim Einführen der Speichereinheit 6 die Ausnehmungen der ersten Leiterplatte 70 und erst danach wird die elektrische Steckverbindung bewirkt.

Somit ist also die Leiterplatte 36 senkrecht zur ersten Leiterplatte 70 und der zur ersten Leiterplatte 70 parallel angeordneten zweiten Leiterplatte 71 sowie dem die Speichereinheit 6 umgebenden Beriech des Wandteils 7 ausgerichtet.

Mittels der elektrischen Steckverbindung zwischen der ersten Leiterplatte 70 und der weiteren Leiterplatte 36 der Speichereinheit 6 ist ein einfaches Verbinden ausführbar. Hierzu sichert die formschlüssige Verbindung der weiteren Leiterplatte 36 im und mit dem Unterteil 37 der Speichereinheit 6 und deren formschlüssige spielfreie Verbindung, insbesondere

Klipsverbindung, mittels der elastisch auslenkbaren Bereiche 33 mit dem Wandteil 7 die Speichereinheit 6. Die beiden an dem Unterteil 37 ausgeformten Stiftbereiche 30 zentrieren die Speichereinheit 6 an der ersten Leiterplatte 70.

Ein zusätzlich an dem Unterteil 37 ausgeformter Zentrierbolzen 39 ist am Unterteil 37 ausgeformt und ragt in eine entsprechend geformte weitere Ausnehmung der ersten Leiterplatte 70 hinein. Somit ist eine Zentrierung der Speichereinheit 6 einfach ausführbar.

An dem Oberteil 31 der Speichereinheit 6 sind weitere Rastnasen 38 ausgebildet, welche an dem Wandteil 7 verrastet sind, welches entsprechende, mit den Rastnasen 38 zur Bildung einer Einrastverbindung geeignet geformte Vorsprungsbereiche aufweist. Die Rastnasen 38 weisen Einführschrägen auf, deren Schrägung aber gegenläufig ist zu den an den Rastnasen 32 der elastischen Bereiche 33 ausgebildeten Schrägungen.

Somit werden die elastischen Bereiche 33 beim Einführen der Speichereinheit 6 elastisch zum Unterteil 37 hin zusammengedrückt und die Rastnasen 32 durchqueren die am Wandteil 7 angeordnete Ausnehmung. Nach Entspannen der elastisch auslenkbaren Bereiche 33 liegen die Rastnasen 32 an der Unterseite, also an der der ersten Leiterplatte 70 zugewandten Seite, des Wandteils 7 an, so dass ein Zurückziehen der Speichereinheit 6 blockiert ist. Außerdem liegen die Rastnasen 38 an der anderen Seite, insbesondere also Oberseite, des Wandteils 7 an. Das Wandteil 7 ist also zwischen den am Unterteil 37 ausgeformten und den am Oberteil 31 ausgeformten Rastnasen 38 begrenzt. Anders zugedrückt, ist die Speichereinheit 6 am Wandteil 7 formschlüssig gehalten.

Die Verbindungslinie der beiden Rastnasen 38 ist senkrecht zur Verbindungslinie der beiden Rastnasen 32 ausgerichtet, da die Rastnasen 38 und 32 an unterschiedlichen Seiten der Speichereinheit 6 angeordnet sind.

Auf der Leiterplatte 36 der Speichereinheit 6 ist ein DIP-Schalter 35 bestückt, mit dem unterschiedliche Parametrierungen bewirkbar sind, welche die Arbeitsweise, insbesondere Betriebsart, der auf den Leiterplatte 70 und 71 bestückten Signalelektronik bestimmt. Somit fungiert die Signalelektronik als abhängig von der Schalterstellung der DIP-Schalter 35 unterschiedlicher AS-Interface-Slave-Typ und/oder arbeitet mit einem abhängig von der Schalterstellung der DIP-Schalter 35 unterschiedlichen AS-Interface-Slave-Profil. Abhängig von den Schalterstellungen des DIP-Schalters 35 wird also eine jeweils unterschiedliche Betriebsart der im Deckelteil 9 aufgenommenen Signalelektronik aktiviert, wenn die Speichereinheit 6 eingesteckt wird.

Vorteil ist hierbei, dass für die Realisierung unterschiedlicher AS-Interface-Slave-Profilen oder -Typen keine separaten Elektrogeräte, insbesondere Umrichter, entwickelt werden müssen und dass das Deckelteil 9 mit der darin aufgenommenen Signalelektronik umfassende Elektrogerät für verschiedene Profile und Typen verwendbar ist. Es muss hierzu nur der DIP-Schalter 35 vorgesehen werden und die Schalterstellung des DEIP-Schalters 35 verwendet werden zur Einstellung des jeweils gewünschten AS-Interface-Slave-Profils oder - Typs.

Somit ist bei einer Reparatur ein sehr schneller und einfacher Austausch ermöglicht, indem die Signalelektronik samt Speichereinheit 6 getauscht wird und die DIP-Schalterstellung übernommen wird.

Die zumindest beiden Kerben 40 sind an der Leiterplatte 36 an zwei einander gegenüberliegenden Ränder der Leiterplatte 36 angeordnet.

Das Deckelteil 9 ist vorzugsweise aus Kunststoff ausgeführt. Alternativ ist aber auch eine Ausführung aus Aluminium-Druckguss ermöglicht.

Das Wandteil 7 ist vorzugsweise aus einem isolationsfesten Kunststoff ausgeführt und ist somit auch in der Lage, als Wärmesperre zu fungieren.

Erfindungsgemäß ist also ein Elektrogerät als Umrichtermotor ausgeführt, wobei die Signalelektronik in einem Deckelteil 9 angeordnet ist, in welches ein als Speichereinheit 9 ausgeführtes Speichermodul mittels Rastverbindung oder Klipsverbindung einsteckbar ist, wobei eine Verrastung oder Klipsverbindung mit dem Wandteil 7 vorgesehen ist, das mit dem Deckelteil 9 mittels Schrauben oder Rastverbindung verbunden ist, insbesondere wie auch die erste Leiterplatte 70.

Bei weiteren erfindungsgemäßen Ausführungsbeispielen wird das Deckelteil auf ein Unterteil aufgesetzt und dicht verbunden, wobei das Unterteil auf einem Gehäuseteil eines Elektromotors angeordnet und dicht verbunden ist. Somit ist eine kompakte Ausführung des Elektrogeräts als Umrichtermotor ausführbar.

### Bezugszeichenliste

1 Drehschalter
2 Potentiometer
3 Potentiometer
4 DIP-Schalter
5 DIP-Schalter
6 Speichereinheit
7 Wandteil, insbesondere Wärmesperre
8 Steckverbinderteil
9 Deckelteil
10 Verschlussschraube, insbesondere aus Kunststoff
20 Bein
21 mechanische Schnittstelle für formschlüssigen Eingriff eines Werkzeugs
30 Stiftbereich
31 Oberteil
32 Rastnase
33 elastischer Bereich des Unterteils 37
34 geriffelter Bereich
35 DIP-Schalter
36 Leiterplatte
37 Unterteil
38 Rastnase
39 Zentrierbolzen
40 Kerbe
70 erste Leiterplatte
71 erste Leiterplatte

## Patentansprüche

1. Elektrogerät, insbesondere Umrichter oder Umrichtermotor, mit einem Deckelteil (9) und Signalelektronik,
**wobei** die Signalelektronik eine erste Leiterplatte (70) aufweist und eine mit der ersten Leiterplatte (70), insbesondere mittels elektrischer Steckverbindung, elektrisch steckverbundene Speichereinheit (6),
**dadurch gekennzeichnet, dass**
die Speichereinheit (6) eine Schaltereinheit, insbesondere Wahlschalter, insbesondere DIP-Schalter (4, 5, 35)), aufweist,
insbesondere wobei die Signalelektronik, insbesondere die Betriebsart der Signalelektronik, als abhängig von der Schalterstellung der Schaltereinheit unterschiedliches AS-Interface-Slave-Profil und/oder als abhängig von der Schalterstellung der Schaltereinheit unterschiedlicher AS-Interface-Slave-Typ fungiert,
**wobei die Speichereinheit (6) eine weitere** Leiterplatte **(36) aufweist, die in einem Gehäuse der Speichereinheit (6) aufgenommen ist,**
**wobei das Gehäuse ein Unterteil und ein mit dem Unterteil verbundenes Oberteil (31) aufweist,**
**am Unterteil zumindest ein Stiftbereich (30) ausgebildet ist, welcher in eine Ausnehmung der ersten Leiterplatte (70) eingesteckt ist, insbesondere zur vorauseilenden Führung der Speichereinheit (6) beim Steckverbinden der weiteren Leiterplatte (36), insbesondere von als Kontakte fungierende Leiterbahnen der weiteren Leiterplatte (70), mit der ersten Leiterplatte (70), insbesondere mit einem auf der ersten Leiterplatte (70) bestückten Steckverbinderteil (8),**
**das Oberteil (31) mit dem Unterteil formschlüssig mittels Klipsverbindung verbunden ist.**

2. Elektrogerät nach Anspruch 1,
**dadurch gekennzeichnet, dass**
ein Wandteil (7) mit dem Deckelteil (9) verbunden ist, insbesondere mittels Schrauben oder mittels Rastverbindung,
wobei die erste Leiterplatte (70) zwischen dem Wandteil (7) und dem Deckelteil (9) angeordnet ist, insbesondere wobei die erste Leiterplatte (70) mit dem Deckelteil (9) verbunden ist.

3. Elektrogerät nach einem der vorangegangenen Ansprüche,
**dadurch gekennzeichnet, dass**
das Wandteil (7) aus Kunststoff gefertigt ist und/oder das Deckelteil (9) aus Metall, insbesondere als Aluminiumdruckgussteil, gefertigt ist,
insbesondere wobei das Wandteil (7) als Wärmesperre fungiert, insbesondere als Wärmesperre zwischen der Signalelektronik und einem Elektromotor, mit dessen Gehäuseteil das Deckelteil (9) verbunden ist.

4. Elektrogerät nach einem der vorangegangenen Ansprüche,
**dadurch gekennzeichnet, dass**
am Unterteil zumindest zwei elastisch auslenkbare, insbesondere an einander gegenüberliegenden Seiten des Unterteils angeordnete, Bereiche ausgebildet sind,
an welchen jeweils eine erste Rastnase (32) ausgebildet ist, insbesondere zur formschlüssigen Verbindung.

5. Elektrogerät nach einem der vorangegangenen Ansprüche,
**dadurch gekennzeichnet, dass**
zwischen dem Wandteil (7) und dem Deckelteil (9) eine zweite Leiterplatte angeordnet ist,
insbesondere wobei die zweite Leiterplatte parallel zur ersten Leiterplatte (70) und/oder von der ersten Leiterplatte (70) beabstandet angeordnet ist.

6. Elektrogerät nach einem der vorangegangenen Ansprüche,
**dadurch gekennzeichnet, dass**
die erste Leiterplatte (70) mit einem Steckverbinderteil (8), insbesondere Buchsenleiste, bestückt ist,
wobei die weitere Leiterplatte (36) der Speichereinheit (6) steckverbunden ist mit dem Steckverbinderteil (8),
insbesondere wobei an der weiteren Leiterplatten (36) angeordneten Leiterbahn als Kontakte fungieren, die mit Kontakten des Steckverbinderteils (8) elektrisch lösbar verbunden sind.

7. Elektrogerät nach einem der vorangegangenen Ansprüche,
**dadurch gekennzeichnet, dass**
die elastisch auslenkbaren Bereiche an ihrer von der weiteren Leiterplatten (36) abgewandten Seite einen geriffelten, gerändelten und/oder aufgerauten Bereich aufweisen, insbesondere zur Erhöhung der Griffigkeit.

8. Elektrogerät nach einem der vorangegangenen Ansprüche,
**dadurch gekennzeichnet, dass**
die Rastnase (32) an der der ersten Leiterplatte (70) zugewandten Seite des Wandteils (7) anliegt.

9. Elektrogerät nach einem der vorangegangenen Ansprüche,
**dadurch gekennzeichnet, dass**
eine am Unterteil und/oder Oberteil (31) ausgebildete, insbesondere ausgeformte, Rastnase (32) an der von der ersten Leiterplatten (70) abgewandten Seite des Wandteils (7) anliegt.

10. Elektrogerät nach einem der vorangegangenen Ansprüche,
**dadurch gekennzeichnet, dass**
die weiteren Leiterplatten (36) Vertiefungen, insbesondere Einkerbungen, aufweist, in welche an dem Oberteil (31) oder Unterteil ausgebildeten, insbesondere ausgeformten, elastisch verformbaren Rastnasen hineinragen.

11. Elektrogerät nach einem der vorangegangenen Ansprüche,
**dadurch gekennzeichnet, dass**
die am Unterteil und/oder Oberteil (31) ausgebildete, Rastnase (32) eine Schrägung aufweist, welche mit zunehmendem Abstand von dem oder den Stiftbereichen (30) einen abnehmenden Abstand zur weiteren Leiterplatte (36) aufweist.

12. Elektrogerät nach einem der vorangegangenen Ansprüche,
**dadurch gekennzeichnet, dass**
den jeweiligen, am elastisch auslenkbaren Bereich ausgebildete Rastnase (32) eine Einführschräge aufweist, welche mit zunehmendem Abstand von dem oder den Stiftbereichen (30) einen **zu**nehmenden Abstand zur weiteren Leiterplatte (36) aufweist.

13. Elektrogerät nach einem der vorangegangenen Ansprüche,
**dadurch gekennzeichnet, dass**
die weitere Leiterplatte (36) mit der Schaltereinheit und einem insbesondere langzeitstabilen Datenspeicher bestückt ist.

14. Elektrogerät nach einem der vorangegangenen Ansprüche,
**dadurch gekennzeichnet, dass**
am Unterteil und/oder Oberteil (31) ein Zentrierbolzen ausgebildet ist, der von dem oder den Stiftbereichen (30) beabstandet ist und in eine weitere, insbesondere durchgehende, Ausnehmung der ersten Leiterplatte (70) ragt,
und/oder dass
das Wandteil (7) Ausnehmungen aufweist, durch welche hindurch mit einem Werkzeug Eingabeelemente, insbesondere Potentiometer (2), Drehschalter (1) oder weitere DIP-Schalter (4, 5, 35)), bedienbar sind.

15. Elektrogerät nach einem der vorangegangenen Ansprüche,
**dadurch gekennzeichnet, dass**
auf der ersten Leiterplatte (70) zumindest ein Potentiometer (2) angeordnet ist und das Deckelteil (9) eine mit einem Verschlussteil, insbesondere Verschlussschraube (10), abgedeckte Ausnehmung aufweist,
wobei das Potentiometer (2) mittels eines bei entfernter Verschlussschraube (10) durch die Ausnehmung hindurchragendem Schraubendreher betätigbar ist.

## Claims

1. Electrical device, in particular a converter or a converter motor, comprising a cover part (9) and signal electronics,
the signal electronics having a first circuit board (70) and a storage unit (6) electrically plug-connected to the first circuit board (70), in particular by means of an electrical plug connection,
**characterised in that**
the storage unit (6) has a switch unit, in particular a selector switch, in particular a DIP switch (4, 5, 35),
the signal electronics, in particular the operating mode of the signal electronics, acting in particular as a different AS-Interface slave profile depending on the switch position of the switch unit and/or as a different AS-Interface slave type depending on the switch position of the switch unit,
the storage unit (6) having a further circuit board (36) received in a housing of the storage unit (6),
the housing having a bottom part and a top part (31) connected to the bottom part,
at least one pin region (30) being formed on the bottom part and being inserted into a cut-out in the first circuit board (70), in particular in order to guide the storage unit (6) in a leading manner when plug-connecting the further circuit board (36), in particular conducting tracks of the further circuit board (70) which act as contacts, to the first circuit board (70), in particular to a plug connector part (8) fitted on the first circuit board (70),
the top part (31) being interlockingly connected to the bottom part by means of a clip connection.

2. Electrical device according to claim 1,
**characterised in that**
a wall part (7) is connected to the cover part (9), in particular by means of screws or by means of a latching connection,
the first circuit board (70) being arranged between the wall part (7) and the cover part (9), the first circuit board (70) in particular being connected to the cover part (9).

3. Electrical device according to any of the preceding claims,
**characterised in that**
the wall part (7) is made of plastics material and/or the cover part (9) is made of metal, in particular is produced as an aluminium diecast part,
the wall part (7) acting in particular as a heat barrier, in particular as a heat barrier between the signal electronics and an electric motor, to the housing part of which the cover part (9) is connected.

4. Electrical device according to any of the preceding claims,
**characterised in that**
at least two resiliently deflectable regions are formed on the bottom part, in particular are arranged on opposite sides of the bottom part,
a first snap-in lug (32) being formed on each of said regions, in particular to establish an interlocking connection.

5. Electrical device according to any of the preceding claims,
**characterised in that**
a second circuit board is arranged between the wall part (7) and the cover part (9),
the second circuit board in particular being arranged in parallel with the first circuit board (70) and/or at a distance from the first circuit board (70).

6. Electrical device according to any of the preceding claims,
**characterised in that**
the first circuit board (70) is fitted with a plug connector part (8), in particular a socket connector,
the further circuit board (36) of the storage unit (6) being plug-connected to the plug connector part (8),
conducting tracks arranged on the further circuit board (36) acting in particular as contacts that are releasably electrically connected to contacts of the plug connector part (8).

7. Electrical device according to any of the preceding claims,
**characterised in that**
on their side facing away from the further circuit board (36), the resiliently deflectable regions have a rippled, knurled and/or roughened region, in particular for increasing grip.

8. Electrical device according to any of the preceding claims,
**characterised in that**
the snap-in lug (32) abuts the side of the wall part (7) that faces the first circuit board (70).

9. Electrical device according to any of the preceding claims,
**characterised in that**
a snap-in lug (32) formed, in particular moulded, on the bottom part and/or on the top part (31) abuts the side of the wall part (7) that faces away from the first circuit board (70).

10. Electrical device according to any of the preceding claims,
**characterised in that**
the further circuit board (36) has recesses, in particular indentations, into which there protrude elastically deformable snap-in lugs formed, in particular moulded, on the top part (31) or on the bottom part.

11. Electrical device according to any of the preceding claims,
**characterised in that**
the snap-in lug (32) formed on the bottom part and/or on the top part (31) has a cant whose distance from the further circuit board (36) decreases as the distance from the pin region(s) (30) increases.

12. Electrical device according to any of the preceding claims,
**characterised in that**
the snap-in lug (32) formed on each resiliently deflectable region has an insertion bevel whose distance from the further circuit board (36) increases as the distance from the pin region(s) (30) increases.

13. Electrical device according to any of the preceding claims,
**characterised in that**
the further circuit board (36) is fitted with the switch unit and a data store that in particular has long-term stability.

14. Electrical device according to any of the preceding claims,
**characterised in that**
a centring bolt spaced apart from the pin region(s) (30) is formed on the bottom part and/or on the top part (31) and protrudes into a further cut-out, in particular a through-going cut-out, in the first circuit board (70),
and/or **in that**
the wall part (7) has cut-outs through which input elements, in particular potentiometers (2), rotary switches (1) or further DIP switches (4, 5, 35), can be operated using a tool.

15. Electrical device according to any of the preceding claims,
**characterised in that**
at least one potentiometer (2) is arranged on the first circuit board (70), and the cover part (9) has a cut-out that is covered by a closure part, in particular a screw plug (10),
the potentiometer (2) being operable by means of a screwdriver that protrudes through the cut-out when the screw plug (10) is removed.

## Revendications

1. Appareil électrique, en particulier convertisseur ou moteur de convertisseur, avec une partie couvercle et une électronique de signal,
l'électronique de signal présentant une première carte de circuit imprimé (70) et une unité de mémoire (6) connectée électriquement à la première carte de circuit imprimé (70), en particulier au moyen d'une connexion électrique enfichable,
**caractérisé en ce que**
l'unité de mémoire (6) présente une unité de commutation, en particulier un commutateur de sélection, en particulier un commutateur DIP (4, 5, 35)),
l'électronique de signal, en particulier le mode de fonctionnement de l'électronique de signal, agissant en particulier comme un profil esclave d'interface AS différent en fonction de la position de commutation de l'unité de commutation et/ou comme un type esclave d'interface AS différent en fonction de la position de commutation de l'unité de commutation,
l'unité de mémoire (6) comprenant une autre carte de circuit imprimé (36) logée dans un boîtier de l'unité de mémoire (6),
le boîtier présentant une partie inférieure (60) et une partie supérieure (31) reliée à la partie inférieure (60),
sur la partie inférieure est formée au moins une région de broche (30) qui est insérée dans un évidement de la première carte de circuit imprimé (70), en particulier en vue d'un guidage anticipé de l'unité de mémoire (6) lors de la connexion par enfichage de l'autre carte de circuit imprimé (36), en particulier de pistes conductrices, faisant office de contacts, de l'autre carte de circuit imprimé (70), avec la première carte de circuit imprimé (70), en particulier avec une partie connecteur enfichable (8) installée sur la première carte de circuit imprimé (70),
la partie supérieure (31) est reliée à la partie inférieure au moyen d'une liaison par clipsage.

2. Appareil électrique selon la revendication 1,
**caractérisé en ce que**
une partie paroi (7) est reliée à la partie couvercle (9), en particulier au moyen de vis ou d'une liaison par encliquetage,
la première carte de circuit imprimé (70) étant agencée entre la partie paroi (7) et la partie couvercle (9), la première carte de circuit imprimé (70) étant en particulier reliée à la partie couvercle (9).

3. Appareil électrique selon l'une quelconque des revendications précédentes,
**caractérisé en ce que**
la partie paroi (7) est fabriquée en plastique et/ou la partie couvercle (9) est fabriquée en métal, en particulier sous la forme d'une pièce moulée sous pression en aluminium, la partie paroi (7) faisant en particulier office de barrière thermique, en particulier de barrière thermique entre l'électronique de signal et un moteur électrique à la partie carter duquel la partie couvercle (9) est reliée.

4. Appareil électrique selon l'une quelconque des revendications précédentes,
**caractérisé en ce que**
au moins deux régions pouvant être déviées de manière élastique sont formées sur la partie inférieure, en particulier sur des côtés opposés de la partie inférieure,
respectivement un premier ergot d'encliquetage (32) étant formé sur lesdites au moins deux régions, en particulier en vue d'une liaison avec blocage par complémentarité de forme.

5. Appareil électrique selon l'une quelconque des revendications précédentes,
**caractérisé en ce que**
une deuxième carte de circuit imprimé est agencée entre la partie paroi (7) et la partie couvercle (9),
la deuxième carte de circuit imprimé étant en particulier agencée parallèlement à la première carte de circuit imprimé (70) et/ou à distance de la première carte de circuit imprimé (70).

6. Appareil électrique selon l'une quelconque des revendications précédentes,
**caractérisé en ce que**
la première carte de circuit imprimé (70) est équipée d'une partie connecteur enfichable (8), en particulier d'une barrette de connexion,
l'autre carte de circuit imprimé (36) de l'unité de mémoire (6) étant connectée par enfichage à la partie connecteur enfichable (8),
les pistes conductrices agencées au niveau de l'autre carte de circuit imprimé (36) faisant en particulier office de contacts qui sont connectés de manière électriquement amovible aux contacts de la partie connecteur enfichable (8).

7. Appareil électrique selon l'une quelconque des revendications précédentes,
**caractérisé en ce que**
les régions pouvant être déviées de manière élastique présentent une région cannelée, striée et/ou rugueuse sur leur côté opposé à l'autre carte de circuit imprimé (36), en particulier afin d'augmenter l'adhérence.

8. Appareil électrique selon l'une quelconque des revendications précédentes,
**caractérisé en ce que**
l'ergot d'encliquetage (32) repose sur le côté de la partie paroi (7) tourné vers la première carte de circuit imprimé (70).

9. Appareil électrique selon l'une quelconque des revendications précédentes,
**caractérisé en ce que**
un ergot d'encliquetage (32) formé, en particulier moulé, sur la partie inférieure et/ou la partie supérieure (31) repose sur le côté de la partie paroi (7) qui est opposé à la première carte de circuit imprimé (70).

10. Appareil électrique selon l'une quelconque des revendications précédentes,
**caractérisé en ce que**
les autres cartes de circuits imprimés (36) présentent des renfoncements, en particulier des encoches, dans lesquels pénètrent des ergots d'encliquetage formés sur la partie supérieure (31) ou la partie inférieure, en particulier des ergots d'encliquetage déformables élastiquement.

11. Appareil électrique selon l'une quelconque des revendications précédentes,
**caractérisé en ce que**
l'ergot d'encliquetage (32) formé sur la partie inférieure et/ou la partie supérieure (31) présente un chanfrein qui présente une distance décroissante par rapport à l'autre carte de circuit imprimé (36) à mesure que la distance par rapport à la ou aux région(s) de broche (30) augmente.

12. Appareil électrique selon l'une quelconque des revendications précédentes,
**caractérisé en ce que**
l'ergot d'encliquetage (32) respectif formé sur la région pouvant être dévié de manière élastique présente une pente d'insertion qui présente une distance croissante par rapport à l'autre carte de circuit imprimé (36) à mesure que la distance par rapport à la ou aux région(s) de broches (30) augmente.

13. Appareil électrique selon l'une quelconque des revendications précédentes,
**caractérisé en ce que**
l'autre carte de circuit imprimé (36) est équipée de l'unité de commutation et d'une mémoire de données en particulier stable à long terme.

14. Appareil électrique selon l'une quelconque des revendications précédentes,
**caractérisé en ce que**
un boulon de centrage, espacé de la ou des région(s) de broche (30) et faisant saillie dans un autre évidement, en particulier continu, de la première carte de circuit imprimé (70), est formé sur la partie inférieure et/ou la partie supérieure (31),
et/ou **en ce que**
la partie paroi (7) présente des évidements à travers lesquels des éléments d'entrée, en particulier un potentiomètre (2), un commutateur rotatif (1) ou d'autres commutateurs DIP (4, 5, 35), peuvent être utilisés grâce à un outil.

15. Appareil électrique selon l'une quelconque des revendications précédentes,
**caractérisé en ce que**
au moins un potentiomètre (2) est agencé sur la première carte de circuit imprimé (70) et la partie couvercle (9) présente un évidement recouvert par une partie de fermeture, en particulier une vis de fermeture (10),
le potentiomètre (2) pouvant être actionné au moyen d'un tournevis traversant l'évidement lorsque la vis de fermeture (10) est retirée.
